# EUROPEAN PATENT SPECIFICATION

(11) **EP 1 496 583 B1**
(45) Date of publication and mention of the grant of the patent: **18.05.2016**
(21) Application number: 03015307.6
(22) Date of filing: 07.07.2003
(51) Int. Cl.: H01S 5/183, H01S 5/065

(54) **A vertical cavity surface emitting laser having improved transverse mode control and a method of forming the same**
Oberflächenemittierender Laser mit vertikalem Resonator mit verbesserter Kontrolle der transversalen Moden und Herstellungsverfahren desselben
Laser à émission de surface à cavité verticale possédant un contrôle amélioré des modes transversaux et méthode de fabrication associée

(43) Date of publication of application: 12.01.2005
(73) Proprietor: II-VI Laser Enterprise GmbH, 8045 Zürich (CH)
(72) Inventor: Royo, Paul, 8055 Zürich (CH)
(74) Representative: Talbot-Ponsonby, Daniel Frederick

(56) References cited:
- EP-A- 0 772 266
- WO-A-99/57789
- WO-A-02/073753
- DE-A- 10 105 722
- US-A1- 2002 044 581
- US-A1- 2002 126 720
- CHANG C-H ET AL: "PARASITICS AND DESIGN CONSIDERATIONS ON OXIDE-IMPLANT VCSELS" IEEE PHOTONICS TECHNOLOGY LETTERS, IEEE INC. NEW YORK, US, vol. 13, no. 12, December 2001 (2001-12), pages 1274-1276, XP001076755 ISSN: 1041-1135
- NISHIYAMA N ET AL: "MULTI-OXIDE LAYER STRUCTURE FOR SINGLE-MODE OPERATION IN VERTICAL-CAVITY SURFACE-EMITTING LASERS" IEEE PHOTONICS TECHNOLOGY LETTERS, IEEE INC. NEW YORK, US, vol. 12, no. 6, June 2000 (2000-06), pages 606-609, XP000951817 ISSN: 1041-1135

## Description

The present invention generally relates to vertical cavity surface emitting lasers (VCSEL) comprising a first reflector and a second reflector to define a resonator, wherein a laser active region is located between the first and the second reflector. Moreover, the VCSEL under consideration includes an aperture layer so as to control optical losses of higher-order transverse radiation modes, thereby providing a single transverse mode emission or emission with a reduced output wavelength range.

VCSEL devices are considered an attractive alternative to conventional double-heterostructure laser diodes due to their small size and their potentiality of being formed in a substantially circular symmetry. Generally, VCSEL devices show a relatively low threshold current, a high modulation efficiency and, if designed so as to emit a substantially circular beam profile, allow to be coupled into optical fibers in a simple fashion. Additionally, the manufacture of VCSEL devices comes along with a parallel and cost-effective production, testing and packaging process, and also offers the possibility of being packed densely in one and two-dimensional arrays to comply with a plurality of applications such as data communication, sensing applications, and the like.

VCSEL devices inherently operate in a single longitudinal radiation mode due to their short cavity length. On the other hand, typically a plurality of transverse radiation modes are simultaneously present within the resonator, wherein the spectral purity, i.e., the number, width and intensity of wavelengths being present in the output radiation, is substantially defined by the lateral geometry of the VCSEL device. It appears, however, that in certain applications it is important to provide a high spectral purity or a substantially monochromatic emission, such as in spectroscopy applications. A substantially single mode emission, that is, emission of a single longitudinal and transverse radiation mode, is also highly desirable for applications such as positioning, laser printing, or short distance optical interconnections. In a typical VCSEL device having a multimode radiation behavior, an increased transverse mode competition may be observed as the drive current increases, resulting in unstable, non-symmetric, and large divergence angle beam profiles. The multimode behavior entails a plurality of drawbacks in high bit rate data communication systems owing to dispersion effects and also leads to a decrease of spatial and temporal coherence as well as to an increase of noise.

From the plurality of generic VCSEL structures presently known, devices having a selectively oxidized aperture layer have become the subject of intense research and development due to their superior electrical and optical properties compared to alternative structure designs. VCSEL devices having an oxidized aperture layer are available as standard products for a wide range of emission wavelengths. The oxidized aperture layer is typically arranged within the resonator - which is often provided in the form of first and second distributed Bragg reflectors - in the vicinity of the laser active region so as to laterally confine the electric current and the optical field prevailing within the resonator. It turns out, however, that a complex interaction of thermal lensing, spatial hole-burning, self-focusing and non-uniform current injection necessitates the provision of very small oxide apertures in a range of 3-4 micrometers so as to allow an operation of the VCSEL device in a single transverse mode regime, that is, with the emission of the fundamental transverse radiation mode only. The characteristic lateral dimension of approximately 3-4 µm, in turn, causes a large differential resistance, an increased thermal impedance, and a high density of the injected current, which finally reduces the reliability and lifetime of the VCSEL device, especially when moderate output powers are required. Additionally, VCSEL devices of this type may require high operation voltages and may exhibit increased divergence angles. A further drawback of VCSEL devices including very small oxide apertures is their high sensitivity to electrostatic discharge (ESD), which also contributes to a reduced reliability of the device. Moreover, since tight tolerances for manufacturing the apertures are required, production yield may be reduced, thereby rendering these devices less attractive for mass application.

In view of the above-identified problems, it is therefore an object of the present invention to provide a technique that enables to manufacture VCSEL devices having apertures larger than 3-4 µm while still providing a substantially single mode radiation at moderate power levels.

According to one aspect of the present invention, the object is solved by a VCSEL device having the features defined in claim 1.

The VCSEL device in accordance with the present invention has a design in which the lateral confinement of the optical field is determined by the interaction of the aperture and the lateral dimension of a portion of the first reflector rather than by an oxide aperture alone. Due to the combined effect of the first and second characteristic lateral sizes the optical losses of the higher order radiation modes are higher compared to the effect of the aperture alone so that the lateral size thereof may be increased compared to conventional approaches without compromising the single mode emission behavior of the VCSEL device. Consequently, the current density through the aperture, and hence through the laser active region, is decreased, thereby significantly increasing the reliability and lifetime of the VCSEL device for a specified required output power. A further advantage resides in the fact that the operating behavior of the VCSEL device is substantially determined by lateral dimensions of the device so that the required device behavior may be adjusted in a simple and cost-efficient manner during manufacturing of the device. Moreover, since the device behavior is significantly influenced and thus in a high degree determined by at least two device dimensions, a deviation of one dimension during the manufacturing process may be compensated for, at least partially, by adjusting the other one of the characteristic lateral sizes in correspondence with the deviation of the first dimension. This allows a higher degree of flexibility and an increased reproducibility of the manufacturing process.

In a further embodiment, the radiation output window has a third characteristic lateral size that is less than the first and the second characteristic lateral sizes, the third characteristic lateral size being representative of a characteristic measure of the lateral extension of the radiation ouput window. By correspondingly selecting the lateral dimension of the radiation output window, the selective optical conferment of the fundamental transverse radiation mode may still further be enhanced. Moreover, by appropriately selecting the first, second and third characteristic lateral sizes, the far field beam shape may be correspondingly adjusted.

In a further variant, the radiation output window is formed in a metal layer, which may comprise any appropriate material or materials, for example, in the form of two or more sub-layers, to provide for the required optical and electrical characteristics. Advantageously, the metal layer is used as a first electrode to inject current into the laser active region.

In a further embodiment, the first characteristic lateral size is equal to or greater than 5µm. By correspondingly selecting the size of the aperture in this order of magnitude, the device reliability and lifetime may be increased for a required output power, wherein merely well-established manufacturing techniques are required in fabricating the device.

In a further variant, the first characteristic lateral size is equal to or greater than 6 µm. In this case, a significant enlargement of the aperture is achieved compared to conventional devices so that output powers can exceed 1 mW, while still maintaining the output wavelength variation substantially within a range of a few nanometers.

In a further variant, an absolute amount of the difference of the first characteristic lateral size and the second characteristic lateral size is in the range of approximately 6 µm or less. The above-specified range enables the fabrication of reliable VCSEL devices having a required small output wavelength range at an increased output power even for an aperture size being considerably greater than in conventional devices, wherein fluctuations of the first and/or the second characteristic lateral sizes are substantially non-critical as along as the difference is in the range of 6 µm. In a preferred variant, the difference of the first and second characteristic lateral sizes is in the range of approximately 4 micrometers and less, thereby still further enhancing the transverse mode selectivity.

In other illustrative embodiments, the third characteristic lateral size is in the range of approximately 4-7 µm. As previously explained, the lateral dimension of the radiation output window may assist, in combination with a proper selection of the first and second characteristic lateral sizes, in obtaining a superior transverse mode selection and/or in shaping the beam profile in the far field of the laser device.

In a further preferred embodiment, the VCSEL device further comprises a third plurality of doped layers having alternately a low index of refraction and a high index of refraction, wherein the third plurality of doped layers is disposed between the aperture and the second plurality of doped layers. By means of the third plurality of doped layers, a distance between the aperture layer and the second plurality of doped layers, which forms a portion of the first reflector and exhibits the second characteristic lateral size, can be adjusted so as to further enhance the efficiency of suppressing higher-order transverse radiation modes of the aperture and/or the second plurality of doped layers. For instance, depending on the optical characteristics of the doped layers, not more than approximately 7-9 or preferably not more than 5 layers may result in an optimum selectivity efficiency of the aperture layer and the second plurality of doped layers.

In a further variant, the aperture layer is formed between the first plurality of doped layers and the third plurality of doped layers so that a distance of the aperture from the active region may be adjusted by appropriately selecting the number of individual layers in the first plurality of doped layers. This enables, in combination with the lateral size of the aperture, to control the efficiency in mode confinement and mode selection of the aperture. For instance, the number of layers of the first plurality may be selected to 9 or less, and more preferably to 5 or less.

In a further embodiment, the second reflector comprises a plurality of doped layers having alternatively a low index of refraction and a high index of refraction. Thus, the second reflector may be designed in a similar fashion as the first reflector, wherein the layers are doped and provided in number so as to obtain the required reflectivity of the resonator formed by the first and second reflectors.

In a further preferred embodiment, the VCSEL device comprises a substrate carrying the second reflector on one surface thereof and further including a metal layer formed on the opposite surface of the substrate. Thus, the metal layer may conveniently be used as a second electrode for generating a current flow through the laser active region.

In a further embodiment, the VCSEL device comprises a contact layer formed between the laser active region and at least a portion of the second reflector, wherein the contact layer is configured to electrically connect the active region to a contact pad. In this embodiment, the provision of a substrate and a corresponding metal layer formed thereon may be rendered obsolete, since driving a current through the laser active region may be accomplished by a top electrode, for instance, in the form of a metal layer having formed therein the radiation output window, and the contact layer in combination with the contact pad acting as a second electrode. Thus, an extremely compact configuration may be obtained when the substrate for forming the VCSEL device is removed after completion of the device.

According to the invention, the first characteristic lateral size is greater than the second characteristic lateral size. In this regime, the aperture defines a gain region, i.e., an effective resonator region, that preferentially supports the fundamental mode with a reduced gain for high order modes, whereas the second plurality of doped layers acts as a mode filter that suppresses the higher order modes in a very efficient manner.

Advantageously, with the aperture greater than the characteristic lateral size of the second plurality of doped layers, the radiation output window may also act as a mode filter enhancing the modal discrimination. Moreover, when the radiation output window is formed in a metal layer acting as a first electrode, a substantially uniform current injection into the center of the laser active region is accomplished.

In a further variant, the aperture and the second plurality of doped layers have a substantially circular shape and the first and second characteristic lateral sizes represent a first diameter and a characteristic second diameter, respectively. This arrangement results in an output beam having a circular symmetry, thereby achieving simplicity in coupling the output beam into an optical fiber.

In a further variant, the radiation output window has a substantially circular shape to provide for a circular symmetry in the output beam.

In a further embodiment, at least one of the aperture and the second plurality of doped layers has a non-circular shape to provide different optical losses for different polarization states of a low-order radiation mode of the specified wavelength range. Since the lateral asymmetry of the aperture and/or the second plurality of doped layers favors one of two possible polarization states of the fundamental transverse radiation mode, a further improvement in the spectral purity is obtained over a wide range of drive currents. In a further variant the radiation output window may have a non-circular shape to provide for different optical losses for different polarization states of the fundamental transverse radiation mode of the specified wavelength range. The non-circular shape of the radiation output window may be provided in addition to or alternatively to an asymmetry of the aperture and/or the second plurality of doped layers, thereby further enhancing the polarization stability and providing an efficient means for stabilizing a polarization state, respectively.

In another illustrative embodiment a non-circular aperture and/or second plurality of doped layers may be combined with a substantially circular radiation output window so as to maintain a substantially circular beam shape, at least in the vicinity of the radiation output window, while still maintaining a superior behavior with respect to polarization state changes.

In a further embodiment, the VCSEL device comprises a phase matching layer arrange within the resonator, wherein the phase matching layer is configured to laterally pattern the reflectivity of the resonator. Preferably, an optical thickness of the phase matching layer is adapted so as to provide an increased reflectivity at lateral positions with a high probability for the fundamental mode and a low reflectivity at positions of increased amplitudes of the higher-order modes. With the provision of the phase matching layer, which defines a further characteristic lateral dimension regarding the mode confinement and mode selectivity, the performance of the device may further be enhanced and may allow an increased aperture size without significantly compromising the device behavior.

According to another aspect of the present invention, a method of forming a vertical cavity surface emitting laser comprises the features defined in claim 22.

As previously explained, two or more dimensions may be determined in mutual dependency from each other so as to obtain a "synergetic" effect with respect to the separation of higher order transverse radiation modes compared to the individual optimisation of one or more of these characteristic dimensions. Thus, the present invention allows to obtain increased output powers at a true single transverse mode regime or within a predefined restricted wavelength range by determining in advance appropriate ranges for at least two of the above-identified characteristic dimensions. Advantageously, process variations may be compensated for during the manufacturing process based on the determined correlation should measurement results indicate a significant deviation of one or more of the characteristic dimensions. Moreover, since at least a plurality of the specified characteristic device dimensions are in the lateral dimension rather than in the depth dimension, the device behavior may be adjusted, at least within a wide range, by the appropriate selection of lateral dimensions so that two or more different types of laser devices may conveniently be fabricated on the same substrate, thereby merely requiring an adapted set of lithography masks. As a consequence, an efficient and cost effective technique is provided that allows the fabrication of high power laser devices having an increased spectral purity, wherein well-established conventional process technologies may be used.

In a further embodiment, the minimum acceptable lateral size is selected so as to maintain a current density below a critical threshold for an output power of one mW and more. With a corresponding selection of the minimum lateral size, device reliability may be significantly increased, whereby output power and spectral purity is maintained at a required high level.

In a further variant, the minimum acceptable lateral size may be selected to 5 µm or more, and in other embodiments the size may be selected to 6 µm or more. A substantially single mode operation may be achieved with output powers in excess of 1 mW for a diameter of the aperture in the range of approximately 5-15 µm and even more. Due to the corresponding low current density through the aperture and thus through the laser active region, a continuous operation with extended lifetimes may be accomplished.

In a further embodiment correlating at least two characteristic dimensions includes varying one or more of the characteristic dimensions while keeping at least one characteristic dimension constant and determining at least one of an output power and an output wavelength for a specified operating range. Thus, an efficient method is provided that enables to establish a correlation between two or more characteristic dimensions of the VCSEL device, wherein additionally output power and spectral purity are taken into consideration. Consequently, specific application requirements may be met on the basis of the established correlation.

In one illustrative embodiment, correlating the at least two characteristic dimensions includes the calculation of an optical field within the resonator for a plurality of value combinations of said at least two characteristic dimensions. Consequently, a correlation between two or more characteristic dimensions may conveniently be obtained in advance. In other variants, measurement results may be obtained from VCSEL devices that are actually fabricated in accordance with the established correlation so as to verify and/or update the calculations previously performed.

In a further embodiment, process margins for the at least two characteristic dimensions are specified on the basis of the established correlation.

Further preferred embodiments are set forth in the appended claims.

In the following further illustrative embodiments of the present invention will now be described with reference to the appended drawings, in which:
Figs. 1a depict 5a schematic cross-sectional view of an inventive structure of a VCSEL device;
Figs 1b and c depict schematic cross-sectional views of comparative structures of a VCSEL device
Fig. 1d and 1e schematically show a top view of a VCSEL device in accordance with the present invention, wherein a non-symmetric design provides for an enhanced polarization stability; and
Figs. 2a-2e represent graphs illustrating output power and spectral purity within a specified range of operating voltages and operating drive currents, wherein a lateral size of an aperture is varied from approximately 6 µm to approximately 14 µm with a corresponding adaptation of a diameter of an overlying second mesa so as to obtain a correlation between characteristic dimensions and an output power and/or a spectral purity.

Throughout this application, any absolute positional designation, such as vertical, horizontal, top, bottom and the like is to be meant as a position with respect to a substrate on which the VCSEL device is formed, irrespective of whether or not the substrate is removed after the completion of the VCSEL device. Consequently, a top emitting VCSEL device is a device emitting radiation through a surface that is located at the distal side of a substrate used during manufacturing the device. Designations such as "above" and "bellow" thus refer to a direction of increasing distance from the substrate and a direction of decreasing distance from the substrate, respectively. Therefore, any reference to an absolute positional designation should not be considered as limiting the present invention unless such a limitation is explicitly recited in the claims.

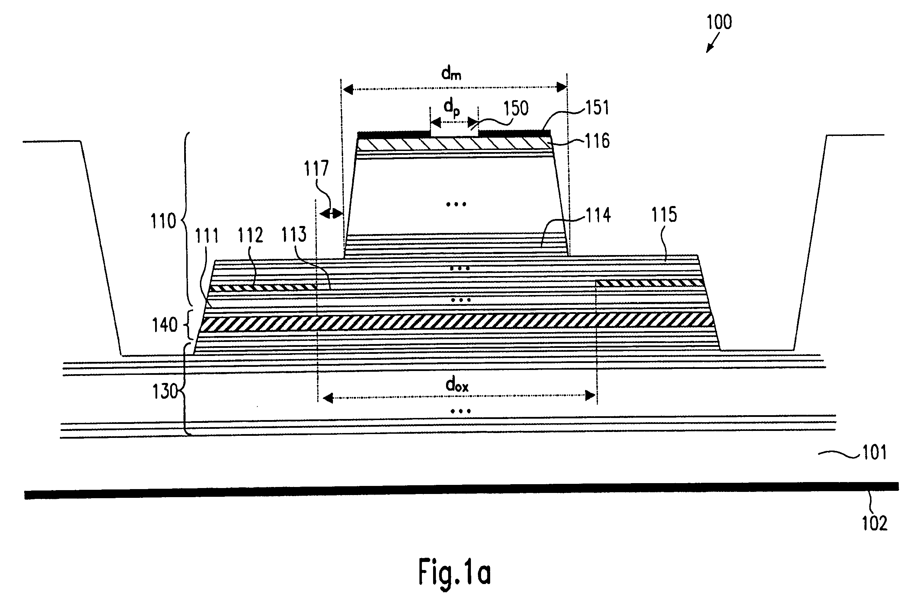

Fig. 1a schematically shows a cross-sectional view of a VCSEL device 100 comprising a first reflector 110 and a second reflector 130 with a laser active region 140 disposed therebetween. Moreover, a substrate 101, for instance a gallium arsenide substrate or any other appropriate semiconductor substrate is provided and carries the second reflector 130 on one side thereof and has formed thereon a metal layer 102, acting as an electrode, formed on the opposite surface of the substrate 101. The second reflector 130 that forms, in combination with the first reflector 110, a laser resonator may comprise a plurality of doped layers having alternately a higher index of refraction and a lower index of refraction, wherein an optical thickness of the individual doped layers is selected so as to provide for a required high reflectivity of the second reflector 130. The concept of a distributed Bragg reflector is well known in the art and a detailed description thereof is thus omitted here. It should be noted that other reflector designs may be adopted for the second reflector, if appropriate. The laser active region 140 may comprise a plurality of suitable semiconductor layers having an arbitrarily desired electrical configuration such as an n-i-p structure, or a p-i-n structure, or any other electrical configuration that is deemed appropriate.

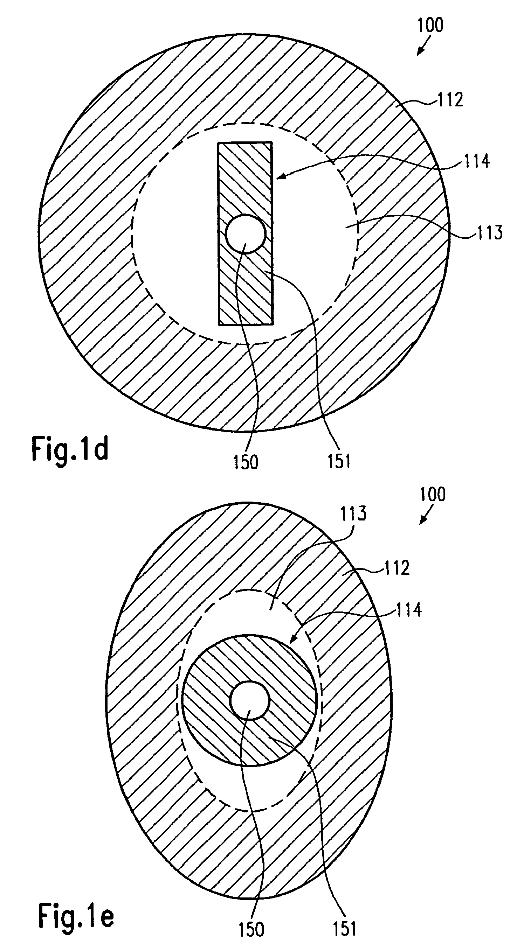

The first reflector 110 comprises a first plurality of doped layers 111 having alternately a lower index of refraction and a higher index of refraction. Located above the first plurality of doped layers 111 is an aperture layer 112 having formed therein an aperture 113 with a characteristic lateral size dₒₓ. The aperture layer 112 is formed of an electrically insulating and optically non-transparent material, such as gallium arsenide with a high amount of aluminium oxide, whereas the aperture 113 is comprised of electrically conductive material that is optically transparent for a specified wavelength range. In one particular embodiment, the first plurality of doped layers 111 and the aperture layer 112 are provided in a substantially circular shape so that the characteristic lateral dimension or size of the aperture 113 is represented by its diameter. In other embodiments, as will be described with reference to Figs. 1e and 1f, the first plurality of doped layers 111 and the aperture layer 112, and thus the aperture layer 113, may have a non-circular shape. Irrespective of the specific shape of the aperture 113, the characteristic lateral size thereof dₒₓ is meant to represent a characteristic measure of the lateral extension of the aperture 113 and thus of the effect of confining the optical field and the current supplied to the laser-active region 140.

The first reflector 110 further comprises a second plurality of doped layers 114 having a characteristic lateral size or dimension dₘ that is less than a lateral extension of the first plurality of the doped layers 111 and that is correlated to the characteristic lateral size dₒₓ of the aperture 113, as will be explained in more detail below. A difference of the characteristic lateral sizes dₒₓ and dₘ is twice a spacing 117 in Fig. 1a. The composition, degree of doping, and thus the variation in the index of refraction of the doped layers of the second plurality 114 may be identical to that of the first plurality 111, so that in combination a required reflectivity of the first reflector 110 is achieved. In one preferred embodiment, the second plurality of doped layers 114 is provided in a substantially circular shape, wherein, as illustrated, a diameter of the individual layers may vary in accordance with a height of the second plurality of doped layers 114. It should be appreciated, however, that a characteristic lateral size, such as the diameter for a circular configuration, may still be defined, irrespective whether the individual diameters may vary. For instance, the characteristic lateral size dₘ may be defined as the diameter at the foot of a small mesa formed by the second plurality of doped layers 114. However, any other appropriate selection of the characteristic lateral size may be used. In other embodiments, the second plurality of doped layers 114 may have a non-circular shape and the characteristic lateral size dₘ may be selected as the dimension in one predetermined lateral direction or may be defined as an average value of the dimensions in two lateral directions.

In one preferred embodiment, the first reflector 110 may further comprise a third plurality of doped layers 115 having alternately a lower index of refraction and a higher index of refraction. By selecting the number of doped layers of the third plurality of doped layers 115 a distance, and thus an optical efficiency in confining the lateral transverse radiation mode of the aperture 113 and/or the second plurality of doped layers 114, that is, of the small mesa formed thereof, may be adjusted. Similarly, by appropriately selecting the number of layers in the first plurality of doped layers 111, the efficiency of current confinement and optical confinement of the aperture 113 may be adjusted. Thus, the number of layers in the first and third pluralities of doped layers 111 and 115, and thus their thickness, may represent characteristic dimensions of the VCSEL device 110 that may effectively be taken into consideration when designing the VCSEL device 110 for a specified output power with a required spectral purity, i.e., with a specified small range of wavelengths output by the device 100.

The VCSEL device 100 further comprises a radiation output window 150 having a characteristic lateral size dₚ, which is less than the characteristic lateral sizes dₘ and dₒₓ. In a preferred embodiment, the radiation window 150 is formed by means of an opening in a metal layer 151 that may act as an electrode for supplying current to the laser-active region 140. As previously pointed out with reference to the aperture 113 and the second plurality of doped layers 114, the radiation output window 150 may advantageously have a substantially circular shape. In other embodiments, the radiation output window 150 may have a non-circular shape so as to provide an asymmetry with respect to two lateral dimensions, thereby enhancing stability with respect to polarization changes during operation of the device 100.

In one embodiment, as illustrated in Fig. 1a, a phase matching layer 116 may be provided, wherein an optical thickness of the phase matching layer 116 is selected so as to efficiently pattern the lateral reflectivity of the resonator formed by the first and second reflectors 110 and 130. To this end, the thickness of the phase matching layer 116 is selected so as to provide, in combination with the metal layer 151, a substantially destructive interference, thereby lowering the total reflectivity of the resonator at lateral positions having a higher probability for higher order transverse radiation modes, whereas the reflectivity below the radiation output window 150 is maintained high. It should be noted that in other embodiments the phase matching layer 116 may be provided at any appropriate position within the first and/or the second reflectors 110 and 130 or may be provided as one or more sub-layers the combined effect of which provides for the desired lateral reflectivity patterning.

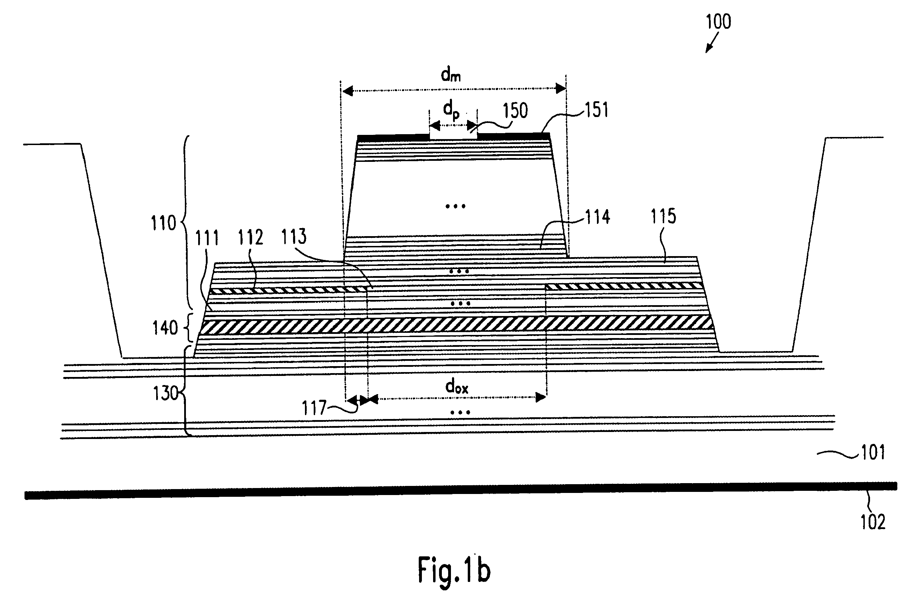

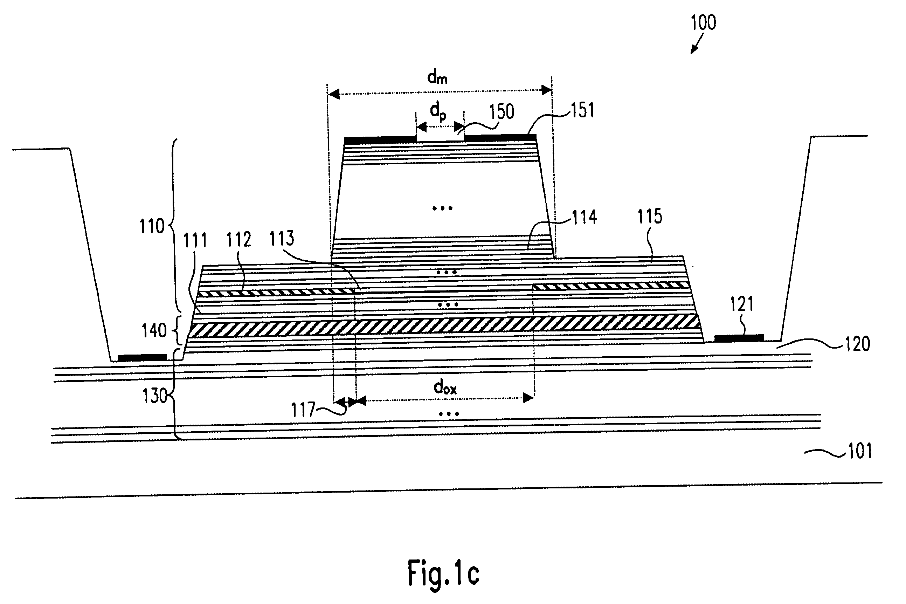

Fig. 1b schematically shows a comparative VCSEL device 100 without the phase matching layer 116 and with a configuration in which the characteristic lateral size dₒₓ of the aperture 113 is less than the characteristic lateral size dₘ of the second plurality of doped layers 114. Regarding the further structural configuration, the same criteria apply as already pointed out with reference to Fig. 1 a.

In the VCSEL device 100 characteristic dimensions are correlated to each other so as to provide high output power with a substantially single transverse mode emission or with a reduced range of output wavelengths, wherein the characteristic lateral size dₒₓ of the aperture 113 may be at least 5 µm or more. Preferably, the characteristic lateral size dₒₓ is 6 µm and more, and may range up to 14 µm or even more. Depending on the size dₒₓ, the characteristic lateral size dₘ of the second plurality of doped layers 114 is correspondingly selected such that optical losses of higher transverse radiation modes are greater compared to the optical losses that would be obtained by the aperture 113 alone. Hence, although the optical confinement of the fundamental transverse mode obtained by the increased aperture 113 may not be as effective as in conventional devices, which require an aperture size as small as 3-4 µm, the combined effect of the lateral size of the second plurality of doped layers 114 and the aperture 113, and possibly of further characteristic dimensions of the device 110, may provide for the required mode selectivity, wherein at least some of the problems caused by extremely small aperture sizes may be avoided or at least significantly reduced. For instance, the characteristic lateral size dₘ may be correlated to the size of the aperture 113 dₒₓ in such a manner that a difference of these two values is equal to or less than approximately 6 µm, and preferably equal to or less than 4 µm. Advantageously, the characteristic lateral size of the radiation output window 150 may be selected so as to act as a further mode filter, thereby additionally enhancing the mode selectivity within the device 100. For instance, the characteristic lateral size dₚ may be selected in the range between approximately 3-7 µm. Moreover, the optical thickness of the first and/or the third plurality of doped layers 111, 115, i.e., the number of individual layers, may be selected so as to obtain a significant effect of the aperture 113 and of the second plurality of doped layers 114, i.e., of the upper small mesa in Figs. 1a and 1b, with respect to confinement of the fundamental transverse radiation mode and mode selectivity. For a typical example of a gallium arsenide based device 100, the number of layers within the third plurality of doped layers 115 may be selected to be preferably 9 and less, and more preferably 5 layers and less. Similarly, the number of doped layers in the first plurality 111 may be selected to 9 and less, and more preferably to 5 and less for a gallium arsenide based layer.

A typical process flow for manufacturing the device 100 as illustrated in Fig. 1 a or Fig. 1 b may comprise the following processes. First, a basic design and appropriate materials are selected for a specified output wavelength. For instance, a gallium arsenide based device may be formed having a target output wavelength of approximately 850 nm with an output power of 1 mW or more. Moreover, the electrical configuration of the laser active region 140 may be selected. Next, the second reflector 130 may be formed by epitaxial growth of a desired number of layers having alternately a lower index of refraction and a higher index of refraction. Since these growth techniques are well established in the art, a detailed description thereof is omitted here. Thereafter, the laser active region 140, comprised of a specified number of doped and non-doped semiconductive layers is formed by well-established techniques. Next, the first plurality of doped layers 111 is formed as a laterally non-patterned layer stack in accordance with conventional growth techniques, wherein the lateral patterning will be accomplished by an etch process, as is described later on. As previously noted, the total number of individual layers may be selected in accordance with the size of the aperture 113, dₒₓ, and the characteristic lateral size of the second plurality of doped layers 114, dₘ. Typically, this number should not be too high so as to not unduly compromise the current and optical field confinement effect of the aperture 113. Next, the aperture layer 112 is formed in a laterally non-patterned fashion by, for example, providing an increased amount of aluminium within the layer 112 to obtain a high oxidation rate during the formation of the aperture 113, as will be described later on. Thereafter, the third plurality of doped layers 115 may be formed as a laterally non-patterned layer stack in conformity with well-established growth techniques, wherein the total number of individual layers may be selected to obtain a required high efficiency in optical field confinement and mode selectivity of the second plurality of doped layers 114. Then, the second plurality of doped layers 114 is formed as a laterally non-patterned layer stack, wherein, as will be readily appreciated, the formation of the first reflector 110 is an epitaxial growth sequence that may be performed without interrupting the sequence when forming the first plurality 111, the aperture layer 112, the third plurality 115 and the second plurality 114. Depending on whether the phase matching layer 116 is provided or not, the epitaxial growth sequence may be completed by forming the phase matching layer 116 having an optical thickness so as to increase the total reflectivity of the first and second reflectors 110 and 130 below the radiation output window 150, while decreasing the reflectivity below the metal layer 151. A corresponding optical thickness of the phase matching layer 116 may be calculated in advance. If the phase matching layer 116 is provided at any other vertical position, or is provided as plural sub-layers, the growth sequence has to be correspondingly adapted. Finally, the metal layer 151, which may be comprised of a plurality of individual sub-layers, is deposited and patterned so as to form the radiation output window 150. The patterning process is performed on the basis of the lateral size dₚ, as may be dictated by the correlation of characteristic device dimensions, as explained above. It should be noted that prior to the deposition of the metal layer 151, any anneal cycles for activating the dopants in the various layers of the first and second reflectors and the laser active region may be performed in accordance with well-established manufacturing techniques for VCSEL devices.

Thereafter, a first etch process may be performed so as to define the lateral dimension of the third plurality of doped layers 115 and to expose at least the edge of the aperture layer 112. The precise depth achieved by the anisotropic etch process is not critical as long as the edge of the aperture layer 112 is exposed. For instance, in Figs. 1 a and 1b. the etch process has been continued to also expose the edges of the laser active region 140 and a portion of the layers of the second reflector 130. In a preferred embodiment, a respective etch mask is formed in a substantially circular shape so that each of the individual layers of the first and second reflectors 111, 130 and of the laser active region 140, the edges of which are exposed by the etch process, exhibits a substantially circular shape. In other embodiments, a non-circular etch mask may be used to obtain a correspondingly shaped layer stack, which may then result in a correspondingly shaped aperture 113. For instance, a rectangular shape or an oval shape may be selected to introduce a certain degree of asymmetry in the lateral directions, which may help to maintain an initial polarization state during the operation of the device 100. Thereafter, a selective wet-oxidation process is performed, wherein the increased amount of aluminium in the aperture 112 is converted into aluminium oxide at a specified oxidation rate so that the finally obtained characteristic lateral size dₒₓ of the aperture 113 is substantially determined by the oxidation chemistry, the initial aluminium concentration, the oxidation time, and the mesa shape. Moreover, as previously explained, the shape of the aperture 113 is determined by the etch mask used during the first anisotropic etch process. The parameters of the selective oxidation process may be selected so as to obtain the lateral size dₒₓ within the range specified above. As previously noted, a precise control of the lateral size dₒₓ, however, may require great efforts and may thus lead to significant performance variations in conventional VCSEL devices. Contrary thereto, according to the present invention the device behavior is determined by the interplay of at least two different design dimensions and therefore a deviation of one parameter from a target value may not unduly compromise the device performance.

In other embodiments, the finally obtained lateral size dₒₓ may be determined by measurement and the design values of one or more characteristic dimensions that are correlated to the lateral size dₒₓ, such as the characteristic lateral size dₘ and/or the lateral size of the radiation output window 150 dₚ, may be adapted to the actual size dₒₓ. For instance, one or more test devices formed on the substrate 101 may be subjected to electric and/or optical measurements. A corresponding measurement signal indicative of the actual size dₒₓ may be gathered and used to readjust one or more corresponding design values of other characteristic device dimensions. Thereafter, a second etch mask is formed, thereby defining the characteristic lateral size dₘ, wherein the formation of the etch mask may be carried out on the basis of measurement results, as previously pointed out. In other embodiments, the anisotropic etch process for defining the second plurality of doped layers 114 is controlled so as to adjust the number of layers in the third plurality of doped layers 115, for instance by precisely adjusting the etch time an/or by continuously or regularly determining the current etch depth. Moreover, the second anistropic etch process may also be controlled on the basis of the above-specified measurement results so as to compensate for a variation of the characteristic lateral size dₒₓ by correspondingly adjusting the number of layers in the third plurality of doped layers 115. After completion of the second etch process, the device 100 may be completed by providing electrical connections to the metal layer 151 by, for example, patterning the metal layer 151 so as to include a respective bond pad, and the backside of the substrate 101 by means of the metal layer 102.

During operation of the VCSEL device 100 a relatively low current density through the aperture 113 is achieved due to the increased lateral size dₒₓ thereof, compared to conventional devices operating in the fundamental transverse radiation mode. Due to the synergetic effect of two or more characteristic dimensions of the device 100, which are adjusted in a correlated manner, the spectral purity of the output radiation is maintained, while at the same time the low differential resistance, the low operation voltage, reduced heating effects result in a dramatic increase in lifetime and the reliability compared to the conventional approach of oxide apertures in the range of 3-4 µm. Moreover, depending on the specific application requirements, the far field beam divergence for a G Gaussian fundamental mode emission may be selected in a virtually arbitrary manner by correspondingly selecting the sizes of the radiation output window 150, dₚ, and the size of the aperture 113, dₒₓ, without compromising reliability of the device 100.

As previously explained, during operation of the device 100 in the fundamental mode regime at elevated drive currents, an increased probability for a change of the polarization state may be observed. Thus, in some embodiments of the present invention it may be advantageous to introduce a certain degree of asymmetry with respect to the lateral directions by correspondingly varying the shape of the aperture 113 and/or the second plurality of doped layers 114 and/or the radiation output window 150.

Fig. 1d schematically shows a top-view of an illustrative embodiment having a lateral asymmetry. As shown, the VCSEL device 100 comprises the aperture layer 112 with the aperture 113 in a substantially circular shape, whereas the second plurality of doped layers 114 is provided in a substantially rectangular shape. The metal layer 151 covering the layer stack 114 includes the radiation output window 150, also having a substantially circular shape.

Fig. 1e schematically shows a further illustrative embodiment in a top view, wherein the VCSEL device 100 comprises the aperture layer 112 and thus the aperture 113 in a substantially oval shape, whereas the second plurality of doped layers 114 covered by the metal layer 151, and the radiation output window 150 have a substantially circular shape. It should be appreciated that a wide variety of designs may be used so as to introduce a required asymmetry in the lateral directions. For instance, the radiation output window 150 may be patterned in a rectangular or oval shape so as to impart the desired non-symmetry to the device 100. Moreover, two or more of the lateral dimensions may simultaneously be selected to provide a required asymmetry. For instance, the aperture 113 and the second plurality of doped layers 114 may be formed in a rectangular or oval shape so as to correspondingly enhance the effect of asymmetry with respect to polarization state stability.

Fig. 1c schematically shows a cross-sectional view of a further variant of the device 100, wherein both electrical connections are provided on the top side of the device 100. To this end, a contact layer 120 is additionally provided that is arranged below and in the vicinity of the laser active region 140 and which is in contact with a respective peripheral contact region 121. Regarding the remaining features and components as well as manufacturing processes of the device 100, the same criteria apply as already pointed out with reference to Fig. 1 a and 1 b. It should be noted, however, that during the first anisotropic etch process for exposing the edge of the aperture layer 112, the etch process may preferably be continued so as to also expose the contact layer 120.

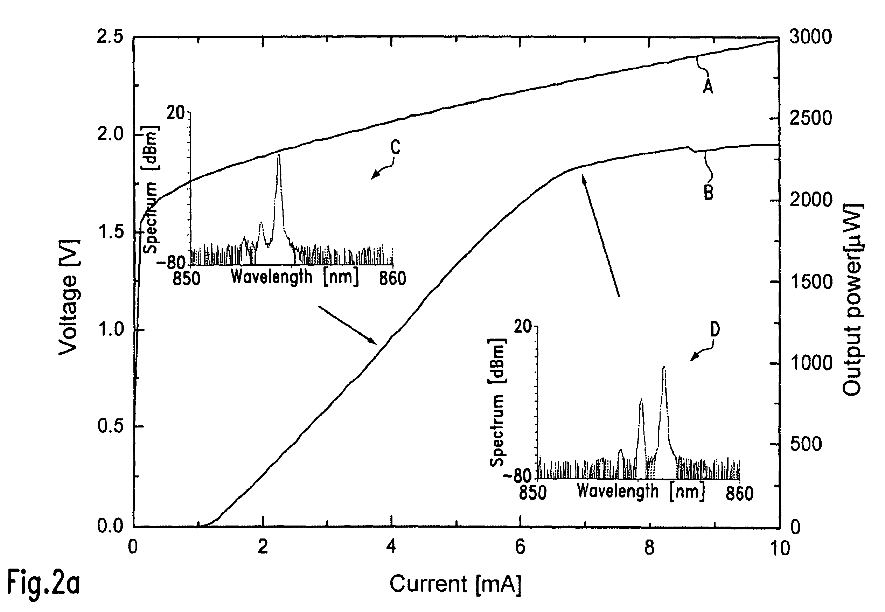

With reference to Figs. 2a-2e, further illustrative embodiments will now be described that relate to the correlation of characteristic dimensions of the VCSEL device 100. In the following, it is referred to a gallium arsenide based VCSEL device intended to operate at a wavelength of approximately 850 nm. It is to be noted, however, that the process of obtaining a correlation between the characteristic device dimensions may be applied to any other VCSEL device structure and configuration and to any desired output wavelength range. Therefore, the following embodiments are to be construed as illustrative only, and should not be considered as being limiting to the present invention.

As previously explained, the combined effect of the characteristic lateral size dₒₓ, dₘ, dₚ, as well as the total number of individual layers in the first and third pluralities of doped layers 111, 115 on the confinement and mode selectivity properties may be determined by simulation calculations. Thus, a correlation for a required degree of mode selectivity, i.e., of spectral purity, may be obtained by corresponding calculations wherein, for instance, one ore more parameters are kept constant, whereas one or more other parameters are varied. Since a plurality of characteristic dimensions may be involved in designing the VCSEL device, a multi-dimensional optimization problem has to be solved. Corresponding calculation algorithms are well known in the art and a detailed description thereof is omitted. For the gallium arsenide based laser, interrelated parameter value ranges as specified above may be obtained as the required correlation between the characteristic device dimensions. For other wavelength the characteristic lateral size dₒₓ, dₘ, dₚ, as well as the total number of individual layers in the first and third pluralities of doped layers 111, 115 may be correspondingly scaled. For instance, a characteristic size dₘ of approximately 10 µm for a wavelength of approximately 850 nm may be scaled to approximately 23 µm for a wavelength of about 2000 nm.

In other embodiments, a correlation is established on the basis of actual measurements and possibly on the basis of simulation calculations.

Fig. 2a illustrates a graph in which the performance of a gallium arsenide based laser device, such as the device 100, is illustrated, wherein the output power and the spectral purity are taken into consideration. Curve A in Fig. 2a represents the output power with respect to the drive current and curve B depicts the operating voltage versus the drive current. Moreover, insert C shows a spectral illustration of the output radiation at a drive current of 4 mA, while insert D shows the spectrum for a drive current of 7 mA. The parameter values for the characteristic device dimension are as follows:

| | |
|---|---|
| dₒₓ | 6 µm; |
| dₘ | 10 µm; |
| dₚ | 4 µm; |

| | |
|---|---|
| number of layers in the first plurality 114 5; number of layers in the third plurality 115 5. | |

As is evident from Fig. 2a, an output power of more than 1 mW is obtained at a drive current of 4 mA, while the output radiation is centred at about 854 nm. When operating the same device at a current of 7 mA, an output power of more than 2 mW is obtained, with a side-mode suppression ratio (SMSR) greater than 20 dB proving the good transverse mode selection achieved by this method..

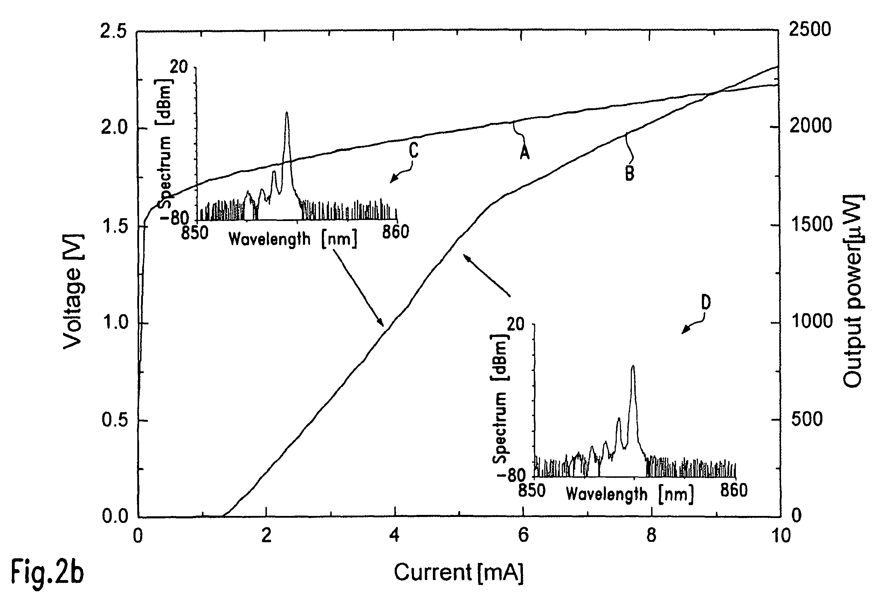

Fig. 2b represents the corresponding graph for parameter values of dₒₓ = 8 µm, dₘ = 12 µm, dₚ = 5 µm, while the number of layers in the first and third pluralities are identical to Fig. 2a.

As shown in Fig. 2b, a similar behavior as in Fig. 2a may be obtained for a drive current of 4 milliamps with an output power of approximately 1 mW, , whereas the SMSR is still greater than 20 dB at 5 mA for an output power of 1.4 mW.

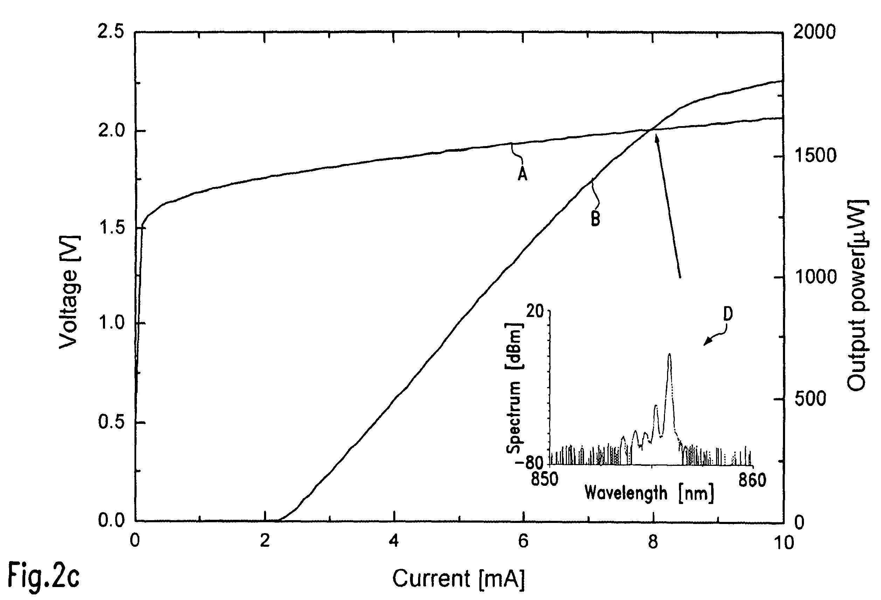

Fig. 2c shows a corresponding graph with the parameter values: dₒₓ = 10 µm, dₘ = 12 µm, dₚ = 5µm, the number of layers unchanged.

At a drive current of 8 mA, an output power of approximately 1.6 mW is obtained, while the SMSR is still greater than 20 dB.

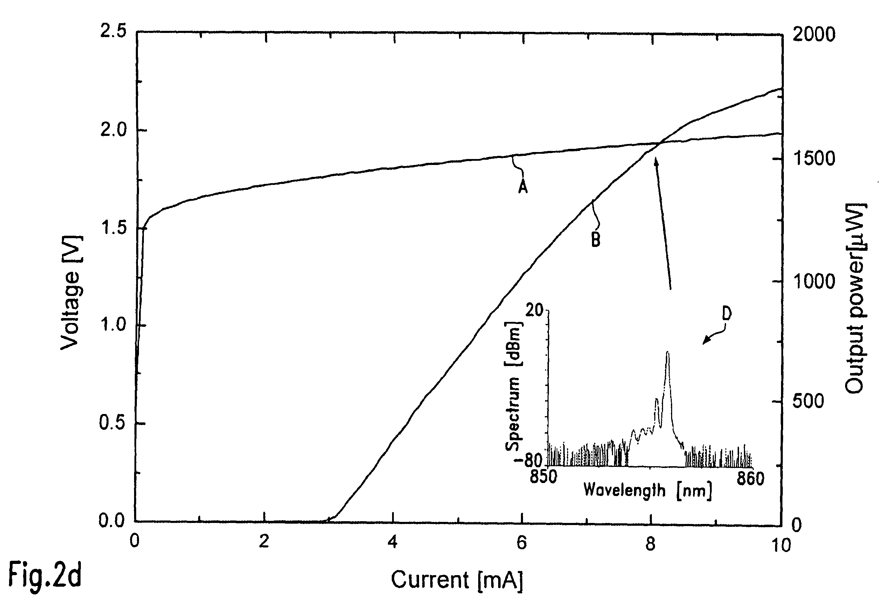

Fig. 2d shows a graph for a further enlarged size of the aperture 113 of 12 µm and for an increased size dₚ = 6µm of the radiation output window 150, wherein the remaining parameter values are identical to those of Fig. 2c. As shown, at a drive current of 8 mA, an output power of more than 1.5 mW is obtained for a SMSR larger than 20 dB.

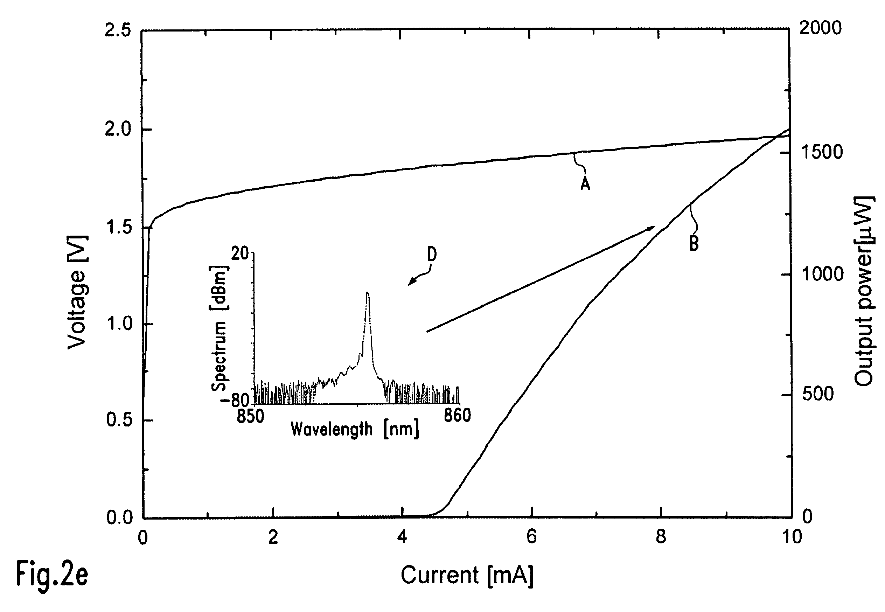

Fig. 2e shows a graph with an aperture size of dₒₓ= 14 µm, while the remaining parameter values remain the same as in Fig. 2d. Evidently, an output power of approximately 1.2 mW is obtained at a drive current of 8 mA for a SMSR larger than 20 dB.

Thus, from these measurements, corresponding mutual dependencies of the various characteristic device dimensions may be derived so as to obtain suitable ranges of the parameter values, thereby taking into account the spectral purity and the output power. The above establishment of a corresponding correlation of characteristic device dimensions is illustrative only and may be extended in any desired way. For instance, a plurality of measurements may be performed so as to estimate output power and spectral purity when the aperture dₒₓ is selected to be less than the lateral size of the small mesa dₘ. Moreover, the range of dₒₓ may be extended to values beyond 14 µm. Similarly, the various shapes of the characteristic device dimensions (cf. Figs. 1d and 1e) may be examined with respect to output power and spectral purity over time so as to estimate the polarization stability. The measurement results may also be combined with corresponding simulation calculations so as to verify or update the model upon which the calculations are based. Moreover, a plurality of different materials and/or electrical configurations may be examined so as to obtain respective correlations. Based on the established correlation, the VCSEL devices according to the present invention are fabricated while a certain degree of in-situ process control is provided in that a variation of one process may be possibly compensated for, at least partially, by correspondingly readjusting a subsequent process on the basis of the correlation and a measurement result, thereby allowing the increase of production yield. Moreover, the performance of the VCSEL device 100 may significantly be affected by lateral device dimensions, such as dₒₓ, dₘ, dₚ and the lateral patterning of the phase matching layer, if provided, so that different types of VCSEL devices may be fabricated simultaneously by correspondingly adapting etch masks and the like, wherein each type may be especially designed for a certain performance, such as single mode operation, multimode operation with reduced width of output wavelength range, different far field divergence, or the like.

As a result, the present invention provides a technique that allows fabrication of VCSEL devices exhibiting substantially single transverse mode emission with large oxide apertures at high output power and a reasonable threshold current. This results in low differential resistance, low voltage, reduced heating effects, and consequently increases the lifetime and reliability compared to conventional devices having a small oxide aperture. The sensitivity to electrostatic discharge is also greatly reduced. Moreover, the process of fabricating the VCSEL device is compatible with well-established fabrication methods and requires merely an additional etch step. Thus, the present invention realizes high performance VCSEL devices in a very cost effective manner.

## Claims

1. Vertical cavity surface emitting laser comprising:
a laser active region (140),
a resonator having a first reflector (110) and a second reflector (130), the first reflector (110) comprising
a first plurality of doped layers (111) having alternately a low index of refraction and a high index of refraction,
an aperture layer (112) located above said first plurality of doped layers (111) and formed of an insulating material that is substantially non-transparent for a specified wavelength range, the aperture layer (112) having an aperture (113) formed of conductive and optically transparent material with a first characteristic lateral size (dₒₓ), said first characteristic lateral size (dₒₓ) being representative of a characteristic measure of the lateral extension of said aperture, and
a second plurality of doped layers (114) having alternately a low index of refraction and a high index of refraction, the second plurality (114) having a second characteristic lateral size (dₘ), said second characteristic lateral size being representative of a characteristic measure of the lateral extension of the second plurality of doped layers (114), the first characteristic lateral size (dₒₓ) being greater than the second characteristic lateral size (dₘ)thereby generating increased optical losses of said resonator with respect to higher order modes for said specified wavelength range compared to the optical losses caused by said aperture layer alone, when arranged within a resonator being provided in the form of first and second distributed Bragg reflectors, and
a radiation output window (150) formed above said first reflector (110) or below said second reflector (130).

2. The vertical cavity surface emitting laser of claim 1, wherein said radiation output window has a third characteristic lateral size that is less than the first and the second characteristic lateral sizes, said third characteristic lateral size being representative of a characteristic measure of the lateral extension of the radiation output window.

3. The vertical cavity surface emitting laser of claim 1 or 2, wherein said radiation output window is formed in a metal layer.

4. The vertical cavity surface emitting laser of any of claims 1 to 3, wherein said first characteristic lateral size is equal to or greater than 5 micrometres.

5. The vertical cavity surface emitting laser of claim 4, wherein said first characteristic lateral size is equal to or greater than 6 micrometres.

6. The vertical cavity surface emitting laser of any of claims 1 to 5, wherein an absolute amount of a difference of the first characteristic lateral size and the second characteristic maximum lateral size is 6 micrometres.

7. The vertical cavity surface emitting laser of any of claims 1 to 5, wherein an absolute amount of a difference of the first characteristic lateral size and the second characteristic maximum lateral size is 4 micrometres.

8. The vertical cavity surface emitting laser of any of claims 2 to 7, wherein said third characteristic lateral size is in the range of 4 to 7 micrometres.

9. The vertical cavity surface emitting laser of any of claims 1 to 8, further comprising a third plurality of doped layers having alternately a low index of refraction and a high index of refraction, the third plurality of doped layers being disposed between said aperture layer and said second plurality of doped layers and having a characteristic lateral size that is greater than said second characteristic size, said characteristic lateral size being representative of a characteristic measure of the lateral extension of said third plurality of doped layers.

10. The vertical cavity surface emitting laser of any of claims 1 to 9, wherein the number of doped layers in said first plurality is equal to or less than 9.

11. The vertical cavity surface emitting laser of claim 9, wherein the number of doped layers in said third plurality is equal to or less than 9.

12. The vertical cavity surface emitting laser of any of claims 1 to 11, wherein said second reflector comprises a plurality of doped layers having alternately a low index of refraction and a high index of refraction.

13. The vertical cavity surface-emitting laser of claim 12, further comprising a substrate carrying said second reflector on one surface and a metal layer formed on the opposite surface of the substrate.

14. The vertical cavity surface emitting laser of any of claims 1 to 12, further comprising a contact layer formed between said laser active region and at least a portion of said second reflector, said contact layer being configured to electrically connect said active region to a contact pad.

15. The vertical cavity surface emitting laser of any of claims 1 to 14, further comprising a phase matching layer formed within said resonator, the phase matching being configured to shape the transverse reflectivity of said resonator so as to suppress higher transverse radiation modes.

16. The vertical cavity surface emitting laser of claim 15, wherein said phase matching layer is provided above said second plurality of doped layers.

17. The vertical cavity surface emitting laser of any of claims 1 to 16, wherein said aperture and said second plurality of doped layers have a substantially circular shape and said first and second characteristic lateral sizes represent a first diameter and a second diameter, respectively.

18. The vertical cavity surface emitting laser of claim 17, wherein said radiation output window has a substantially circular shape.

19. The vertical cavity surface emitting laser of any of claims 1 to 16, wherein at least one of said aperture and said second plurality of doped layers has a non-circular shape to provide different optical losses for different polarization states of a low-order radiation mode of said specified wavelength range.

20. The vertical cavity surface emitting laser of any of claims 17 or 20, wherein said radiation output window has a non-circular shape to provide different optical losses for different polarization states of a low-order radiation mode of said specified wavelength range.

21. The vertical cavity surface emitting laser of any of claims 1 to 20, wherein said second plurality of doped layers forms a mesa.

22. A method of forming a vertical cavity surface emitting laser, the method comprising:
selecting a target output wavelength range,
selecting appropriate semiconductive materials for a laser active region and a first and second reflector, wherein the first reflector includes a first plurality of doped layers and a second plurality of doped layers with an aperture layer arranged therebetween,
determining a minimum acceptable lateral size of an aperture formed in said aperture layer,
correlating at least two of the following characteristic dimensions of the vertical cavity surface emitting laser, a first characteristic lateral size representing a characteristic measure of a lateral extension of said aperture, a second characteristic lateral size representing a characteristic measure of a lateral extension of said second plurality of doped layers, a third characteristic lateral size representing a characteristic measure of a lateral size of a radiation output window, a vertical distance between said laser active region and said aperture layer and a vertical distance between said aperture layer and said second plurality of doped layers, so as to increase optical losses of higher radiation modes beyond those obtained with said minimum acceptable lateral size alone, when being arranged within a resonator being provided in the form of first and second distributed Bragg reflectors, wherein said first characteristic lateral size is equal to or higher than said minimum acceptable lateral size, and
said first characteristic lateral size being greater than the second characteristic lateral size, and
forming said laser active region, said first and second reflectors and said radiation output window according to dimensions determined during said correlating step.

23. The method of claim 22, wherein said minimum acceptable lateral size is selected so as to maintain a current density below a critical threshold for an output power of 1 mWatt and more.

24. The method of claim 23, wherein said minimum acceptable lateral size is 5 micrometres or more.

25. The method of claim 23, wherein said minimum acceptable lateral size is micrometres or more.

26. The method of any of claims 22 to 25, wherein correlating at least two characteristic dimensions includes:
varying one or more of the characteristic dimensions while keeping at least one characteristic dimension constant, and
determining at least one of an output power and an output wavelength for a specified operating range.

27. The method of claim 22, wherein correlating at least two characteristic dimensions includes calculating an optical field within said resonator for a plurality of value combinations and determining a design value range for at least one of the at least two characteristic dimensions for at least one of a desired output power and a spectral purity.

28. The method of claim 22, further comprising specifying process margins for said at least two characteristic dimensions on the basis of said correlation.

## Patentansprüche

1. Oberflächenemittierender Laser mit vertikalem Resonator, umfassend:
einen laseraktiven Bereich (140),
einen Resonator mit einem ersten Reflektor (110) und einem zweiten Reflektor (130), wobei der erste Reflektor (110) umfasst:
eine erste Mehrzahl dotierter Schichten (111), welche alternierend einen niedrigen und einen hohen Brechungsindex aufweisen,
eine Aperturschicht (112), welche oberhalb der ersten Mehrzahl dotierter Schichten (111) angeordnet ist und welche aus einem Isoliermaterial gebildet ist, welches im Wesentlichen in einem spezifischen Wellenlängenbereich nicht transparent ist, wobei die Aperturschicht (112) eine Öffnung (113) aufweist, welche aus leitendem und optisch transparentem Material gebildet ist, mit einer ersten charakteristischen lateralen Größe (dₒₓ), wobei die erste charakteristische laterale Größe (dₒₓ) ein charakteristisches Maß der lateralen Erstreckung der Öffnung darstellt, und
eine zweite Mehrzahl dotierter Schichten (114), welche alternierend einen niedrigen und einen hohen Brechungsindex aufweisen, wobei die zweite Mehrzahl (114) eine zweite charakteristische laterale Größe (dₘ) aufweist, wobei die zweite charakteristische laterale Größe ein charakteristisches Maß der lateralen Erstreckung der zweiten Mehrzahl dotierter Schichten (114) darstellt, wobei die erste charakteristische laterale Größe (dₒₓ) größer als die zweite charakteristische laterale Größe (dₘ) ist, sodass höhere optische Verluste des Resonators in Bezug auf Moden höherer Ordnung für den spezifischen Wellenlängenbereich erzeugt werden, im Verhältnis zu optischen Verlusten, welche von der Aperturschicht alleine verursacht werden, wenn sie innerhalb eines Resonators angeordnet ist, welcher in der Form eines ersten und zweiten verteilten Bragg-Reflektors bereitgestellt wird, und
ein Strahlungsausgangsfenster (150), welches oberhalb des ersten Reflektors (110) oder unterhalb des zweiten Reflektors (130) gebildet ist.

2. Oberflächenemittierender Laser mit vertikalem Resonator nach Anspruch 1, wobei das Strahlungsausgangsfenster eine dritte charakteristische laterale Größe aufweist, welche kleiner als die erste und zweite charakteristische laterale Größe ist, wobei die dritte charakteristische laterale Größe ein charakteristisches Maß der lateralen Erstreckung des Strahlungsausgangsfenster darstellt.

3. Oberflächenemittierender Laser mit vertikalem Resonator nach Anspruch 1 oder 2, wobei das Strahlungsausgangsfenster aus einer metallischen Schicht gebildet ist.

4. Oberflächenemittierender Laser mit vertikalem Resonator nach einem der Ansprüche 1 bis 3, wobei die erste charakteristische laterale Größe größer oder gleich 5 Mikrometer ist.

5. Oberflächenemittierender Laser mit vertikalem Resonator nach Anspruch 4, wobei die erste charakteristische laterale Größe größer oder gleich 6 Mikrometer ist.

6. Oberflächenemittierender Laser mit vertikalem Resonator nach einem der Ansprüche 1 bis 5, wobei der absolute Betrag der Differenz zwischen der ersten charakteristischen lateralen Größe und der zweiten charakteristischen maximalen lateralen Größe gleich 6 Mikrometer ist.

7. Oberflächenemittierender Laser mit vertikalem Resonator nach einem der Ansprüche 1 bis 5, wobei der absolute Betrag der Differenz zwischen der ersten charakteristischen lateralen Größe und der zweiten charakteristischen maximalen lateralen Größe gleich 6 Mikrometer ist.

8. Oberflächenemittierender Laser mit vertikalem Resonator nach einem der Ansprüche 2 bis 7, wobei die dritte charakteristische laterale Größe im Bereich zwischen 4 und 7 Mikrometer liegt.

9. Oberflächenemittierender Laser mit vertikalem Resonator nach einem der Ansprüche 1 bis 8, ferner umfassend eine dritte Mehrzahl dotierter Schichten, welche alternierend einen niedrigen Brechungsindex und einen hohen Brechungsindex aufweisen, wobei die dritte Mehrzahl dotierter Schichten zwischen der Aperturschicht und der zweiten Mehrzahl dotierter Schichten angeordnet ist und eine charakteristische laterale Größe aufweist, welche größer als die zweite charakteristische Größe ist, wobei die charakteristische laterale Größe ein charakteristisches Maß der lateralen Erstreckung der dritten Mehrzahl dotierter Schichten darstellt.

10. Oberflächenemittierender Laser mit vertikalem Resonator nach einem der Ansprüche 1 bis 9, wobei die Anzahl dotierter Schichten in der ersten Mehrzahl kleiner oder gleich 9 ist.

11. Oberflächenemittierender Laser mit vertikalem Resonator nach Anspruch 9, wobei die Anzahl dotierter Schichten in der dritten Mehrzahl kleiner oder gleich 9 ist.

12. Oberflächenemittierender Laser mit vertikalem Resonator nach einem der Ansprüche 1 bis 11, wobei der zweite Reflektor eine Mehrzahl dotierter Schichten umfasst, welche alternierend einen niedrigen und einen hohen Brechungsindex aufweisen.

13. Oberflächenemittierender Laser mit vertikalem Resonator nach Anspruch 12, ferner umfassend ein Substrat, welches den zweiten Reflektor auf einer Oberfläche und eine metallische Schicht auf der entgegengesetzten Seite des Substrats trägt.

14. Oberflächenemittierender Laser mit vertikalem Resonator nach einem der Ansprüche 1 bis 12, ferner umfassend eine Kontaktschicht, welche zwischen dem laseraktiven Bereich und zumindest einen Teil des zweiten Reflektors gebildet ist, wobei die Kontaktschicht ausgebildet ist, um den aktiven Bereich mit einer Kontaktplatte elektrisch zu verbinden.

15. Oberflächenemittierender Laser mit vertikalem Resonator nach einem der Ansprüche 1 bis 14, ferner umfassend eine Phasenanpassungsschicht, welche innerhalb des Resonators gebildet ist, wobei die Phasenanpassung zum Formen der Querreflektivität des Resonators vorgesehen ist, um höhere Querstrahlungsmoden zu unterdrücken.

16. Oberflächenemittierender Laser mit vertikalem Resonator nach Anspruch 15, wobei die Phasenanpassungsschicht oberhalb der zweiten Mehrzahl dotierter Schichten vorgesehen ist.

17. Oberflächenemittierender Laser mit vertikalem Resonator nach einem der Ansprüche 1 bis 16, wobei die Öffnung und die zweite Mehrzahl dotierter Schichten im Wesentlichen kreisförmig sind und die erste und zweite charakteristische laterale Größe jeweils einen ersten und einen zweiten Durchmesser darstellen.

18. Oberflächenemittierender Laser mit vertikalem Resonator nach Anspruch 17, wobei das Strahlungsausgangsfenster im Wesentlichen kreisförmig ist.

19. Oberflächenemittierender Laser mit vertikalem Resonator nach einem der Ansprüche 1 bis 16, wobei die Öffnung und/oder die zweite Mehrzahl dotierter Schichten nicht kreisförmig sind, um unterschiedliche optische Verluste für unterschiedliche Polarisationszustände eines Strahlungsmodus niedriger Ordnung des spezifischen Wellenlängenbereichs bereitzustellen.

20. Oberflächenemittierender Laser mit vertikalem Resonator nach einem der Ansprüche 17 oder 20, wobei das Strahlungsausgangsfenster nicht kreisförmig ist, um unterschiedliche optische Verluste für unterschiedliche Polarisationszustände eines Strahlungsmodus niedriger Ordnung des spezifischen Wellenlängenbereichs bereitzustellen.

21. Oberflächenemittierender Laser mit vertikalem Resonator nach einem der Ansprüche 1 bis 20, wobei die zweite Mehrzahl dotierter Schichten eine Mesa bildet.

22. Verfahren zum Herstellen eines oberflächenemittierenden Lasers mit vertikalem Resonator, wobei das Verfahren umfasst:
Auswählen eines Ausgangswellenlängen-Zielbereichs,
Auswählen passender Halbleitermaterialien für einen laseraktiven Bereich und einen ersten und zweiten Reflektor, wobei der erste Reflektor eine erste Mehrzahl dotierter Schichten und eine zweite Mehrzahl dotierter Schichten aufweist, zwischen denen eine Aperturschicht angeordnet ist,
Bestimmen einer zulässigen lateralen Mindestgröße einer in der Aperturschicht gebildeten Öffnung,
Korrelieren zumindest zwei der folgenden charakteristischen Größen des oberflächenemittierenden Lasers mit vertikalem Resonator, wobei einer erste charakteristische laterale Größe ein charakteristisches Maß einer lateralen Erstreckung der Öffnung darstellt, eine zweite charakteristische laterale Größe ein charakteristisches Maß einer lateralen Erstreckung der zweiten Mehrzahl dotierter Schichten darstellt, eine dritte charakteristische laterale Größe ein charakteristisches Maß einer lateralen Größe eines Strahlungsausgangsfensters darstellt, einen senkrechten Abstand zwischen dem laseraktiven Bereich und die Aperturschicht und ein senkrechter Abstand zwischen der Aperturschicht und eine zweite Mehrzahl dotierter Schichten, um die optischen Verluste höherer Strahlungsmoden zu vergrößern, jenseits derer, welche nur mit der zulässigen lateralen Mindestgröße erhalten sind, wenn sie innerhalb eines Resonators angeordnet sind, welcher aus einem ersten und einem zweiten Bragg-Reflektor gebildet ist, wobei die charakteristische laterale Größe größer oder gleich der zulässigen lateralen Mindestgröße ist, und wobei die erste charakteristische laterale Größe größer als die zweite charakteristische laterale Größe ist, und
Herstellen des laseraktiven Bereichs, des ersten und zweiten Reflektors und des Strahlungsausgangsfensters auf der Basis der während des Korrelierschritts ermittelten Größen.

23. Verfahren nach Anspruch 22, wobei die zulässige laterale Mindestgröße so ausgewählt wird, dass die Stromdichte unterhalb einer kritischen Schwelle für eine Ausgangsleistung von 1 mWatt oder mehr aufrechterhalten wird.

24. Verfahren nach Anspruch 23, wobei die zulässige laterale Mindestgröße größer oder gleich 5 Mikrometer ist.

25. Verfahren nach Anspruch 23, wobei die zulässige laterale Mindestgröße größer oder gleich 6 Mikrometer ist.

26. Verfahren nach einem der Ansprüche 22 bis 25, wobei das Korrelieren von zumindest zwei charakteristischen Größen umfasst:
Ändern einer oder mehrerer der charakteristischen Größen, während zumindest eine charakteristische Größe konstant gehalten wird, und
Bestimmen einer von einer Ausgangsleistung oder einer Ausgangswellenlänge für einen spezifischen Betriebsbereich.

27. Verfahren nach Anspruch 22, wobei das Korrelieren von zumindest zwei charakteristischen Größen das Berechnen eines optischen Feldes innerhalb des Resonators für eine Mehrzahl von Wertkombinationen und das Bestimmen eines Sollwertbereichs für zumindest eine der zumindest zwei charakteristischen Größen für eine gewünschte Ausgangsleistung und/oder eine spektrale Reinheit umfasst.

28. Verfahren nach Anspruch 22, ferner umfassend das Spezifizieren von Prozessspannen für die zumindest zwei charakteristischen Größen auf der Basis der Korrelation.

## Revendications

1. Laser à émission de surface à cavité verticale comprenant :
une région laser active (140),
un résonateur présentant un premier réflecteur (110) et un deuxième réflecteur (130), le premier réflecteur (110) comprenant
une première pluralité de couches dopées (111) présentant alternativement un faible indice de réfraction et un fort indice de réfraction,
une couche à ouverture (112) située au-dessus de ladite première pluralité de couches dopées (111) et constituée dans un matériau isolant sensiblement non transparent pour une plage de longueurs d'onde spécifiée, la couche à ouverture (112) présentant une ouverture (113) constituée dans un matériau conducteur et optiquement transparent en présentant une première taille latérale caractéristique (dₒₓ), ladite première taille latérale caractéristique (dₒₓ) étant représentative d'une mesure caractéristique de l'étendue latérale de ladite ouverture, et
une deuxième pluralité de couches dopées (114) présentant alternativement un faible indice de réfraction et un fort indice de réfraction, la deuxième pluralité (114) présentant une deuxième taille latérale caractéristique (dₘ), ladite deuxième taille latérale caractéristique étant représentative d'une mesure caractéristique de l'étendue latérale de la deuxième pluralité de couches dopées (114), la première taille latérale caractéristique (dₒₓ) étant supérieure à la deuxième taille latérale caractéristique (dₘ), en produisant ainsi des pertes optiques accrues chez ledit résonateur eu égard à des modes d'ordre supérieur pour ladite plage de longueurs d'onde spécifiée par rapport aux pertes optiques causées par ladite couche à ouverture seule, en cas d'agencement dans un résonateur prévu sous la forme de premier et deuxième réflecteurs de Bragg distribués, et
une fenêtre d'émission de rayonnement (150) constituée au-dessus dudit premier réflecteur (110) ou au-dessous dudit deuxième réflecteur (130).

2. Laser à émission de surface à cavité verticale selon la revendication 1, dans lequel ladite fenêtre d'émission de rayonnement présente une troisième taille latérale caractéristique qui est inférieure à la première et à la deuxième taille latérale caractéristiques, ladite troisième taille latérale caractéristique étant représentative d'une mesure caractéristique de l'étendue latérale de la fenêtre d'émission de rayonnement.

3. Laser à émission de surface à cavité verticale selon la revendication 1 ou 2, dans lequel ladite fenêtre d'émission de rayonnement est constituée dans une couche métallique.

4. Laser à émission de surface à cavité verticale selon l'une quelconque des revendications 1 à 3, dans lequel ladite première taille latérale caractéristique est égale ou supérieure à 5 micromètres.

5. Laser à émission de surface à cavité verticale selon la revendication 4, dans lequel ladite première taille latérale caractéristique est égale ou supérieure à 6 micromètres.

6. Laser à émission de surface à cavité verticale selon l'une quelconque des revendications 1 à 5, dans lequel un montant absolu d'une différence entre la première taille latérale caractéristique et la deuxième taille latérale caractéristique maximale est de 6 micromètres.

7. Laser à émission de surface à cavité verticale selon l'une quelconque des revendications 1 à 5, dans lequel un montant absolu d'une différence entre la première taille latérale caractéristique et la deuxième taille latérale caractéristique maximale est de 4 micromètres.

8. Laser à émission de surface à cavité verticale selon l'une quelconque des revendications 2 à 7, dans lequel ladite troisième taille latérale caractéristique se situe dans la plage de 4 à 7 micromètres.

9. Laser à émission de surface à cavité verticale selon l'une quelconque des revendications 1 à 8, comprenant en outre une troisième pluralité de couches dopées présentant alternativement un faible indice de réfraction et un fort indice de réfraction, la troisième pluralité de couches dopées étant disposées entre ladite couche à ouverture et ladite deuxième pluralité de couches dopées, et présentant une taille latérale caractéristique qui est supérieure à ladite deuxième taille caractéristique, ladite taille latérale caractéristique étant représentative d'une mesure caractéristique de l'étendue latérale de ladite troisième pluralité de couches dopées.

10. Laser à émission de surface à cavité verticale selon l'une quelconque des revendications 1 à 9, dans lequel le nombre de couches dopées de ladite première pluralité est égal ou inférieur à 9.

11. Laser à émission de surface à cavité verticale selon la revendication 9, dans lequel le nombre de couches dopées de ladite troisième pluralité est égal ou inférieur à 9.

12. Laser à émission de surface à cavité verticale selon l'une quelconque des revendications 1 à 11, dans lequel ledit deuxième réflecteur comprend une pluralité de couches dopées présentant alternativement un faible indice de réfraction et un fort indice de réfraction.

13. Laser à émission de surface à cavité verticale selon la revendication 12, comprenant en outre un substrat porteur dudit deuxième réflecteur sur une surface et d'une couche métallique constituée sur la surface opposée du substrat.

14. Laser à émission de surface à cavité verticale selon l'une quelconque des revendications 1 à 12, comprenant en outre une couche de contact constituée entre ladite région laser active et au moins une partie dudit deuxième réflecteur, ladite couche de contact étant configurée pour relier électriquement ladite région active à un plot de connexion.

15. Laser à émission de surface à cavité verticale selon l'une quelconque des revendications 1 à 14, comprenant en outre une couche de synchronisme de phase constituée à l'intérieur dudit résonateur, le synchronisme de phase étant configuré pour mettre en forme la réflectivité transversale dudit résonateur de manière à supprimer les modes de rayonnement transversaux d'ordre supérieur.

16. Laser à émission de surface à cavité verticale selon la revendication 15, dans lequel ladite couche de synchronisme de phase est prévue au-dessus de ladite deuxième pluralité de couches dopées.

17. Laser à émission de surface à cavité verticale selon l'une quelconque des revendications 1 à 16, dans lequel au moins ladite ouverture et ladite deuxième pluralité de couches dopées présentent une forme sensiblement circulaire et lesdites première et deuxième tailles latérales caractéristiques représentent respectivement un premier diamètre et un deuxième diamètre.

18. Laser à émission de surface à cavité verticale selon la revendication 17, dans lequel ladite fenêtre d'émission de rayonnement présente une forme sensiblement circulaire.

19. Laser à émission de surface à cavité verticale selon l'une quelconque des revendications 1 à 16, dans lequel ladite ouverture et/ou ladite deuxième pluralité de couches dopées présentent une forme non circulaire visant à assurer différentes pertes optiques pour différents états de polarisation d'un mode de rayonnement d'ordre inférieur de ladite plage de longueurs d'onde spécifiée.

20. Laser à émission de surface à cavité verticale selon l'une quelconque des revendications 17 ou 20, dans lequel ladite fenêtre d'émission de rayonnement présente une forme non circulaire visant à assurer différentes pertes optiques pour différents états de polarisation d'un mode de rayonnement d'ordre inférieur de ladite plage de longueurs d'onde spécifiée.

21. Laser à émission de surface à cavité verticale selon l'une quelconque des revendications 1 à 20, dans lequel ladite deuxième pluralité de couches dopées forment une mesa.

22. Procédé d'élaboration d'un laser à émission de surface à cavité verticale, le procédé comprenant :
le choix d'une plage cible de longueurs d'onde de sortie,
le choix de matériaux semi-conducteurs appropriés pour une région laser active et des premier et deuxième réflecteurs, le premier réflecteur comportant une première pluralité de couches dopées et une deuxième pluralité de couches dopées présentant une couche à ouverture agencée entre elles,
la détermination d'une taille latérale minimale acceptable d'une ouverture constituée dans ladite couche à ouverture,
la corrélation d'au moins deux des dimensions caractéristiques suivantes du laser à émission de surface à cavité verticale, une première taille latérale caractéristique représentant une mesure caractéristique d'une étendue latérale de ladite ouverture, une deuxième taille latérale caractéristique représentant une mesure caractéristique d'une étendue latérale de ladite deuxième pluralité de couches dopées, une troisième taille latérale caractéristique représentant une mesure caractéristique d'une taille latérale d'une fenêtre d'émission de rayonnement, une distance verticale entre ladite région laser active et ladite couche à ouverture et une distance verticale entre ladite couche à ouverture et ladite deuxième pluralité de couches dopées, de manière à accroître les pertes optiques des modes de rayonnement d'ordre supérieur au-delà de celles obtenues avec ladite taille latérale minimale acceptable seule, en cas d'agencement dans un résonateur prévu sous la forme de premier et deuxième réflecteurs de Bragg distribués, dans lequel ladite première taille latérale caractéristique est égale ou supérieure à ladite taille latérale minimale acceptable, et ladite première taille latérale caractéristique est supérieure à la deuxième taille latérale caractéristique, et
la formation de ladite région laser active, desdits premier et deuxième réflecteurs et de ladite fenêtre d'émission de rayonnement conformément aux dimensions déterminées au cours de ladite étape de corrélation.

23. Procédé selon la revendication 22, dans lequel ladite taille latérale minimale acceptable est choisie de manière à conserver une densité de courant inférieure à un seuil critique pour une puissance de sortie de 1 milliwatt et plus.

24. Procédé selon la revendication 23, dans lequel ladite taille latérale minimale acceptable est de 5 micromètres ou plus.

25. Procédé selon la revendication 23, dans lequel ladite taille latérale minimale acceptable est de 6 micromètres ou plus.

26. Procédé selon l'une quelconque des revendications 22 à 25, dans lequel la corrélation d'au moins deux dimensions caractéristiques comporte :
la variation d'une, ou plus, des dimensions caractéristiques tout en maintenant constante au moins une dimension caractéristique, et
la détermination d'une puissance de sortie et/ou d'une longueur d'onde de sortie pour une plage de service spécifiée.

27. Procédé selon la revendication 22, dans lequel la corrélation d'au moins deux dimensions caractéristiques comporte le calcul d'un champ optique dans ledit résonateur pour une pluralité de combinaisons de valeurs et la détermination d'une plage de valeurs de conception pour au moins une des au moins deux dimensions caractéristiques pour une puissance de sortie souhaitée et/ou une pureté spectrale.

28. Procédé selon la revendication 22, comprenant en outre la spécification de marges de processus pour lesdites au moins deux dimensions caractéristiques sur la base de ladite corrélation.
